# EUROPEAN PATENT SPECIFICATION

(11) **EP 0 407 131 B1**
(45) Date of publication and mention of the grant of the patent: **05.10.1994**
(21) Application number: 90307229.6
(22) Date of filing: 02.07.1990
(51) Int. Cl.: H05K 7/10

(54) **Contact**
Kontakt
Contact

(30) Priority: 04.07.1989 JP 172691/89
(43) Date of publication of application: 09.01.1991
(73) Proprietor: Yamaichi Electronics Co., Ltd., Ohta-ku Tokyo (JP)
(72) Inventor: Matsuoka, Noriyuki, Shinagawa-ku, Tokyo (JP)
(74) Representative: Ben-Nathan, Laurence Albert

(56) References cited:
- EP-A- 0 040 942
- US-A- 4 027 935
- US-A- 4 176 895
- US-A- 4 494 807
- US-A- 4 684 184

## Description

### 1. Field of the Invention

This invention relates to a contact for connecting an electric part such as an IC package, etc. and more particularly to a contact of a socket for an electric part which is suitable for incurring an electric signal of high frequency.

### 2. Brief Description of the Prior Art

A contact disclosed in Japanese Utility Model Early Laid-open Publication No. Sho 63-117084 has such a construction as that a bypass bending element having a contact nose at one end portion thereof is displaced downwardly, the contact nose is abutted against a projecting element on the side of a male terminal disposed at the other end portion of the bypass bending portion so as to elastically displace the projecting element against its spring property, thereby to bypass the contact nose and the male terminal.

Another prior art disclosed in Japanese Patent Early Laid-open Publication No. Sho 57-21081 has the construction in that when the contact nose is elastically displaced, a short piece extending from the contact nose side is slided to contact with a spring element, thereby, to bypass the contact nose and the male terminal.

Another prior art disclosed in Japanese Utility Model Early Laid-open Publication No. Sho 63-164191 adopts the construction in that a projecting element projecting toward a contact nose side from a male terminal side is not given an elastic property, and an inclined surface is provided to an inner surface of the projecting element and to an inner surface of the contact nose, so that when the contact nose is displaced downwardly, the inclined surface of the contact nose is abutted against the inclined surface of the projecting element and thereafter displaced backwardly along the inclined surface to generate a pushing force to the contact nose and projecting element, thereby to bypass the contact nose and the male terminal.

In the conventional contacts of this type, as they necessarily possess various tolerances such as dimensional tolerances of contact nose of the counterpart electric part, dimensional tolerances of contacts, socket boards, etc., the displacing amount of the bypass bending element is irregular. However, in the Japanese Utility Model Early Laid-Open Publication No. Sho 63-117084 and Japanese Patent Early Laid-open Publication No. Sho 63-164191, the displacing amount of the bypass bending portion is absorbed by elastically displacing the bypass bending element upwardly, downwardly and backwardly.

However, in Japanese Utility Model Early Laid-open Publication No. Sho 63-117084 and Japanese Patent Early Laid-open Publication No. Sho 57-21081, because the bypass element is warped in order to render a spring property thereto, the distance for bypassing the contact nose and the male terminal is not the shortest. In the latter case, the bypassing distance becomes merely slightly short depending on the significance of irregularities of the displacing amount of the bypass bending element. In addition to that, as the pushing force to the contact nose owing to the elasticity of the bypass element jeopardize a smooth displacement of the bypass element, it is required to strictly adjust the elasticity of the bypass element and that of the bypass bending element and production is difficult.

Furthermore, in Japanese Utility Model Early Laid-open Publication No. Sho 63-164191, it is required to generate a contacting force between the contact element of an electric part and the contact nose of a contact as well as a contacting force between the contact nose and a projecting element by upward, downward and backward displacement of the bypass bending element. Moreover, both the contacting force has different directions of elasticity required for the bypass bending element. Accordingly, designing of the bypass bending element is very difficult and an excessive load is applied to the bypass bending element, thus resulting in a short mechanical life of the bypass bending element.

The present invention has been accomplished in order to obviate these shortcomings.

US-A-4,494,807 illustrates a connector having a contact nose portion and an element elastically supporting the contact nose portion at predetermined angles therebetween. The continuous portion between the contact nose portion and the element serving as a slidable pressure contact portion.

### SUMMARY OF THE INVENTION

As means for solving the above-mentioned problems, the invention provides a connector according to Claim 1.

The stationary contact noses may be arranged in a zigzag form, and male terminals of adjacent stationary contact noses may be disposed in positions equal distance from the pressure contact portion. The contact nose may be formed of a rigid member.

When a pressure is applied to the contact nose when the electric part terminal is placed thereon, the contact nose is displaced downwardly due to elastic displacement of the elastic supporting element to provide a pressure contact with a conductive member of other electric part or a stationary contact element embedded in the connector board. At the same time, while bending the elastic supporting element by serving the pressure contact portion as a supporting point, the circuit between the contact nose of the contact and the conductive element or between the stationary contact elements is shorted. As a result, the bypass object can be achieved by way of the shortest distance between the electric part mounting contact portion and the pressure contacting portion through the contact nose, that is, by way of the shortest distance through the contact element.

### BRIEF DESCRIPTION OF THE DRAWINGS

Fig. 1(A) is a sectional view of a connector using a contact according to one embodiment of the present invention, which is mounted on a wiring board;
Fig. 1(B) is likewise a sectional view showing an electric part mounted and contacted therewith;
Fig. 2(A) is a sectional view of a connector using a contact according to a second embodiment of the present invention, which is mounted on a wiring board;
Fig. 2(B) is likewise a sectional view showing an electric part mounted and contacted therewith;
Fig. 3(A) is a sectional view of a connector using a contact according to a third embodiment of the present invention;
Fig. 3(B) is likewise a sectional view showing an electric part mounted and contacted therewith; and
Fig. 4 is a sectional view of a connector using a contact according to a fourth embodiment of the present invention.

### DETAILED DESCRIPTION OF THE EMBODIMENT

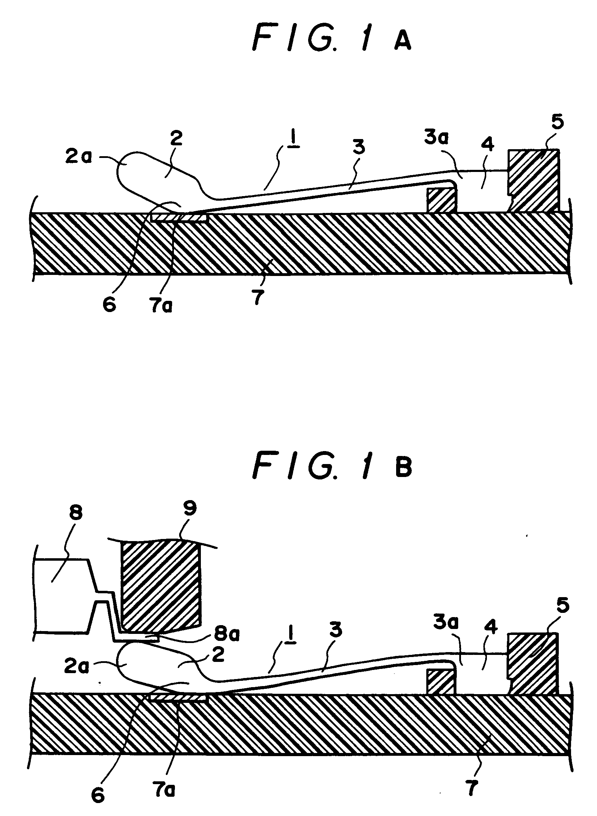

Preferred embodiments of the present invention will be described hereinafter with reference to Figs. 1 through 4 of the accompanying drawings.

### First Embodiment (see Fig. 1)

The reference numeral 1 denotes a contact which is formed of a contact nose 2 and an elastic supporting element 3 for elastically supporting the contact nose 2. The contact nose and the elastic supporting element 3 are continuously formed with each other at predetermined bending angles and such bending portion 6 is served as a pressure contact portion. The free end of the contact nose 2 is served as a mount seat 2a for a terminal 8a of an electric part 8 such as IC, etc. to be placed thereon, and a tail end 3a of the elastic supporting element 3 is embedded in a connector base 5 through a fixed portion 4 formed on the tail end 3a. The contact 1 is elastically displaced by serving the bending portion 6 as a first supporting point and the tail end 3a as a second supporting point.

The connector base 5 is fixed to a wiring board 7 and the pressure contact portion formed of the bending portion 6 formed between the contact nose 2 and the elastic supporting element 3 which form the contact 1 is abutted against and supported by a conductive member 7a of the wiring board 7.

When pressure is applied to the terminal 8a of the electric part 8, which is placed on the mount seat 2a of the contact nose 2 of the contact 1, by a pressure member 9, an elastic displacement force is applied to the elastic supporting element 3 by serving the bending portion 6 (pressure contact portion) as a supporting point. As a result, the elastic supporting element 3 is elastically bent to cause the bending portion 6 to be contacted with the conductive member 7a of the wiring board 7 under pressure. At the same time, a restoring force is generated to the contact nose 2 owing to the elastic supporting element 3 to provide a contact pressure between the electric part terminal 8a and the mount seat 2a. As a result, the conductive member 7a of the wiring board 7 and the electric part terminal are contacted with each other through the contact nose 2. As a result, the bypass object can be achieved by the shortest way through this contact nose 2. That is, there can be obtained a contact which exhibits a favorable characteristics with respect to a signal of high frequency.

Also, when the connector for the electric part is fixed to the wiring board 7, the bending portion 6 (pressure contact portion) for interconnecting the contact nose 2 and the elastic supporting element 3 is required to be placed in such a manner as to correspond to the conductive member 7a of the wiring board 7 either in its contacted state or non-contacted state. It does not necessarily have to be in its contacted state before it is pressurized by the pressure member 9.

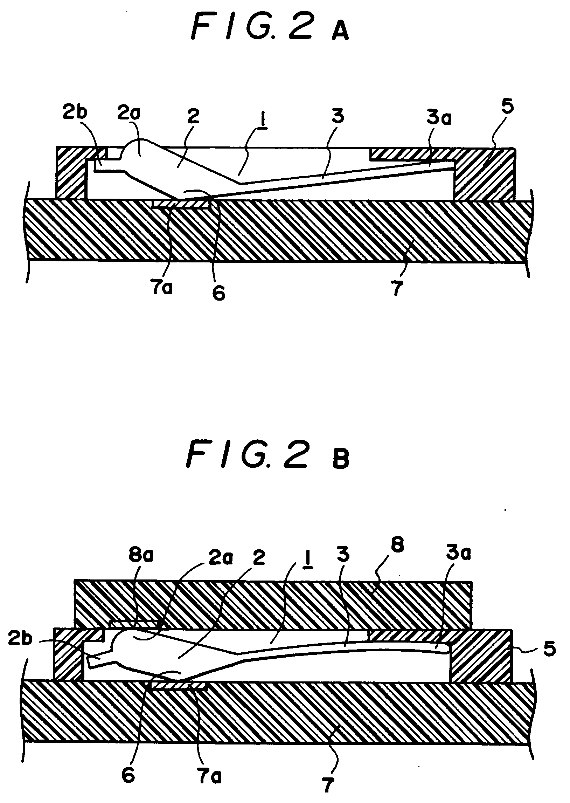

### Second Embodiment (see Fig. 2)

In this embodiment, as is shown in Fig. 2(A), the displaceable contact element 1A is not embedded in the connector base 5 but interposed between the connector base 5 and the wiring board 7. The tail end 3a of the elastic supporting element 3 forming the contact 1 is merely abutted against and supported by the connector base 5 in such a manner as to restrict an upward displacement, and the free end of the contact nose 2 is provided with a projecting piece 2b abutted against and supported by the connector base 5 in such a manner as to restrict the upward displacement. Furthermore, the pressure contact portion formed by the bending portion 6 is abutted against and supported by the conductive member 7a of the wiring board 7. In this way, the contact 1 is disposed in a three-point supported state. The contact 1 serves the bending portion 6 as a first supporting point, the tail end 3a as a second supporting point and the mount seat 2a as the pressurizing point. The contact 1 is elastically displaced by a push-down force applied to the pressurizing point at the first and second supporting points.

In this way, as is shown in Fig. 2(B), when a pressure is applied to the contact nose 2 owing to the electric part terminal 8a placed on the mount seat 2a at the free end of the contact nose 2, the contact nose 2 is displaced downward serving the bending portion as a supporting point while the elastic supporting element 3 is being elastically deformed. As a result, there can be obtained pressure contact with the conductive member 7a. At the same time, both are shorted through the contact nose 2.

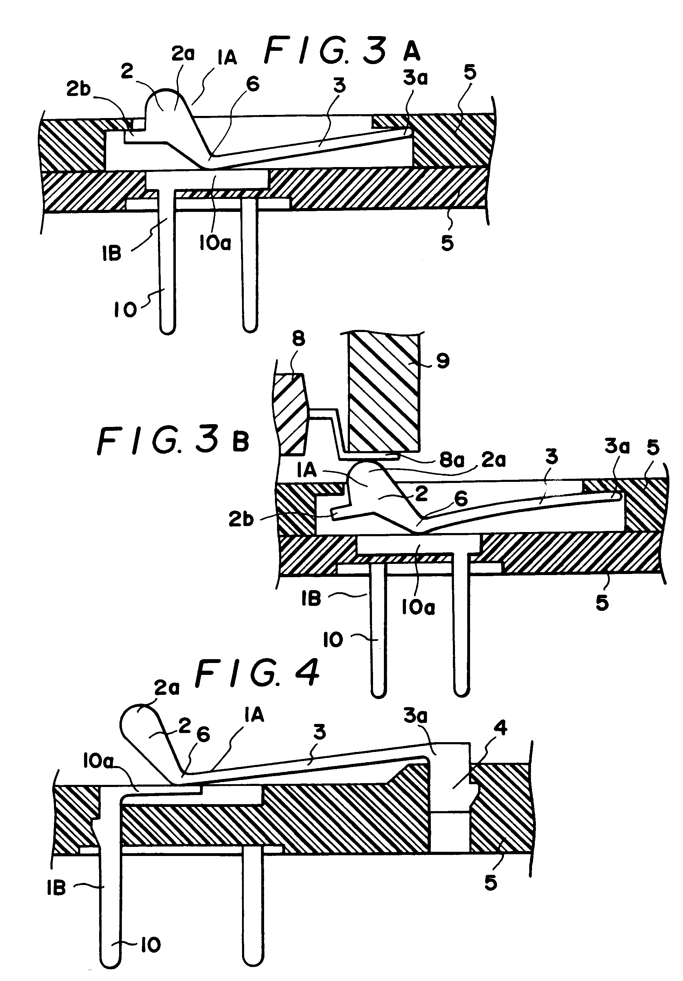

### Third Embodiment (see Fig. 3)

This embodiment, as shown in Fig. 3(A), shows a connector comprising a contact 1 formed of a displaceable contact element 1A and a stationary contact element 1B. The displaceable contact element 1A is formed of a contact nose 2 for contacting with a terminal of an electric part and an elastic supporting element 3 for elastically supporting the contact nose 2, the nose and element 2 and 3 being continuously formed at predetermined angles, such bending portion 6 being served as a supporting point for displacing the elastic supporting element 3 so that the contact nose 2 will be elastically displaced. On the other hand, the stationary element 1B is formed of a made terminal 10 embedded in the connector base 5 and the embedding end portion of the male terminal 10 is formed of a mounting contact element 10a for abutting against and supporting thereon the bending portion 6 of the displaceable contact element 1A.

The free end of the elastic supporting element 3 forming the contact 1 is abutted against and supported by the connector base 5 in such a manner as to restrict an upward displacement, and the free end of the contact nose 2 is provided with a projecting piece 2b which is abutted against and supported by the connector base 5 in such a manner as to restrict the upward displacement. Furthermore, the pressure contact member formed by the bending portion 6 is abutted against and supported by the stationary contact element 1B. In this way, the contact 1 is supported at three points.

When, as is shown in Fig. 3(B), pressure is applied to the mounting contact portion 2a at the free end of the contact nose 2 by the pressure member 9 because the electric part terminal 8a is placed thereon, the contact nose 2 is displaced downward serving the bending portion 6 as a supporting point while accompanying elastic deformation of the elastic supporting element 3 so as to provide a pressure contact of the stationary contact element 1B and a pressure contact of the electric part 8. At the same time, both are shorted through the contact nose 2.

### Fourth Embodiment

This embodiment shows another example, in which the mounting contact element 10a of the stationary contact element 1B of the third embodiment is formed of an elastic piece which is elastically displaced in the pressure applying direction. In this case, the displaceable contact element 1A can be embedded in the connector base 5 through the stationary portion 4 as in the first embodiment.

Also, as still another example, the contact nose 2 of the first through fourth embodiments is formed of a rigid member in order to obtain displacement of the contact nose 2 which is required in order to obtain a pressure contact by the elastic supporting element 3.

As yet another example, the connector is formed in the manner as in the third and fourth embodiment and the stationary contact elements 1B are arranged in a zigzag form, the male terminals 10 of the adjacent stationary terminals being disposed in positions equal distance from the bending portion 6. In this way, a high density embedding can be obtained.

According to the conventional contact, an elastic stroke is obtained with a U-shaped bypass element and therefore, deterioration of high frequency characteristics is invited and a special short circuit means is required in order to properly cope with it. However, according to the present invention, there can be provided a contact of a simple structure which is capable of achieving the bypass object through the shortest distance while obtaining a favorable elasticity which is required to the mounting contact of the electric part terminal.

That is, the contact nose forming the contact provides a favorable pressure contact while bending the elastic supporting element by serving the bending portion (pressure contact portion) by the elastic function of the elastic supporting element, and at the same time, is capable of effectively achieve the bypass object through the shortest distance by way of the contact nose. Also, the contact of the present invention can be greatly reduced in bulk when compared with the conventional contact having the U-shaped bypass element, thus enabling to miniaturize the contact.

## Claims

1. A connector comprising a contact (1) formed of a displaceable contact element (1A) and a stationary contact element (1B), the displaceable contact element being formed of a contact nose (2) adapted to contact with a terminal (8a) of an electric part (8), and an elastic supporting element (3) adapted to elastically support said contact nose, said nose and element being continuously formed at predetermined angles, such continuously formed portion between said nose and element being served as a pressure contact portion (6) for contacting with a conductive member (10a) of said stationary contact element (1B) under pressure, said elastic supporting element being displaced by serving said pressure contact portion as a supporting point and said contact nose being elastically displaced, and said stationary contact element being embedded in a connector base (5) and abutted against and supporting thereon said displaceable contact element through said pressure contact portion.

2. A connector as claimed in Claim 1, wherein when said stationary contact elements are arranged in a zigzag form, male terminals (10) of adjacent stationary contact elements are disposed in positions at equal distance from said pressure contact portion.

3. A connector as claimed in Claim 1 or Claim 2, wherein the contact nose (2) is formed of a rigid member.

4. A connector as claimed in any one of Claims 1 - 3, wherein said elastic supporting element (3) of said contact (1) has a tail end (3a) formed with a fixed portion (4) embedded in said connector base (5).

5. A connector as claimed in any one of Claims 1 - 3, wherein the free end of said contact nose (2) is provided with a projecting piece (2b), and said projecting piece (2b) and the tail end (3a) of said elastic supporting element (3) both engage with parts of said connector base (5) so as to retain said pressure contact portion (6) in contact with said conductive member (7a).

## Patentansprüche

1. Elektrischer Verbinder, bestehend aus einem stationären, in einen Sockel (5) eingebetteten Kontakt (1B) und einem dem Sockel (5) zugeordneten, entspannbaren Zwischenkontakt (IA) mit einem am freien Ende eines federelastischen Stützelementes (3) ausgebildeten Kontakbereich (2) für die Anschlußklemme (8a) eines elektrischen Elementes (8) mit einem unter Beachtung vorgegebener Winkel stetigen Verlauf im Übergangsbereich vom Kontaktbereich (2) in das federelastische Stützelement (3), das einen vom Kontaktbereich (10a) des stationären Kontaktes (IB) hinterfangenen Andruckbereich (6) für die Herstellung eines Kontaktes zwischen dem entspannbaren Zwischenkontakt (IA) und dem stationären Kontakt (IB) ausbildet, wobei die Entspannung des entspannbaren Zwischenkontaktes (IA) in Wechselwirkung des Andrucksbereichs (6) des entspannbaren Zwischenkontaktes (IA) mit dem Kontaktbereich (10a) des stationären Kontaktes (IB) mit einhergehendem Verschwenken des Kontaktbereichs (2) des entspannenden Zwischenkontaktes (IA) erfolgt.

2. Elektrischer Verbinder nach Anspruch 1, dadurch gekennzeichnet, daß die stationären Kontakte (IB) (im Sockel (5)) gegeneinander versetzt angeordnet sind und die (von diesen Kontakten (IB) ausgehenden) Stekkerstifte (10) in übereinstimmendem Abstand vom jeweiligen Andruckbereich (6) des entspannbaren Zwischenkontaktes (IA) gegen den stationären Kontakt (IB) verlaufen.

3. Elektrischer Verbinder nach Anspruch 1 oder Anspruch 2, dadurch gekennzeichnet, daß der Kontaktbereich (2) des entspannbaren Zwischenkontakts (IA) (für das anzuschließende elektrische Element (8)) starr ausgebildet ist.

4. Elektrischer Verbinder nach einem der Ansprüche 1 bis 3, dadurch gekennzeichnet, daß das federelastische Stützelement (3) des entspannbaren Zwischenkontaktes (IA) in einen, in eine am/im Sockel (5) ausgebildete Aufnahme einfügbaren Klemmkörper (4) ausläuft.

5. Elektrischer Verbinder nach einem der Ansprüche 1 bis 3, dadurch gekennzeichnet, daß der Kontaktbereich (2) des entspannbaren Zwischenkontaktes (IA) für das anzusetzende elektrische Element (8) mit einem Überstand (2b) versehen ist und dieser Überstand (2b) sowie der gegenläufige Überstand (3a) des entspannbaren Zwischenkontaktes (IA) in Wechselwirkung mit am Sockel (5) ausgebildeten Widerlagern dergestalt stehen, daß der Andruckbereich (6) (des federelastischen Zwischenkontakts (IA) gegen den Kontaktbereich (10a) des in den Sockel (5) eingebetteten stationären Kontaktes (IB) auch in entspanntem Zustand des federelastischen Zwischenkontaktes (IA)) in Kontakt mit dem Kontaktbereich 10a des stationären Kontaktes (IB) verbleibt.

## Revendications

1. Connecteur comprenant un contact (1) formé d'un élément de contact mobile (1A) et d'un élément de contact fixe (1B), l'élément de contact mobile étant constitué d'un nez de contact (2) destiné à venir en contact avec une borne (8a) d'un composant électrique (8), et d'un élément de support élastique (3) destiné à supporter élastiquement le nez de contact, ce nez et l'élément étant formés de façon continue d'un seul tenant sous des angles prédéterminés, la partie continue ainsi formée entre le nez et l'élément servant de partie de contact de pression (6) destinée à venir en contact sous pression avec un élément conducteur (10a) de l'élément de contact fixe (1B), l'élément de support élastique étant déplacé en se servant de la partie de contact de pression comme d'un point de support tandis que le nez de contact est déplacé élastiquement, et l'élément de contact fixe étant noyé dans une base de connecteur (5) et venant buter contre l'élément de contact mobile en étant supporté par celui-ci par la partie de contact de pression.

2. Connecteur selon la revendication 1, caractérisé en ce que les éléments de contact fixes sont disposés sous une forme en zigzag tandis que les bornes mâles (10) d'éléments de contact fixes adjacents sont disposés dans des positions à égale distance de la partie de contact de pression.

3. Connecteur selon l'une des revendications 1 et 2, caractérisé en ce que le nez de contact (2) est constitué d'un élément rigide.

4. Connecteur selon l'une quelconque des revendications 1 à 3, caractérisé en ce que l'élément de support élastique (3) du contact (1) comporte une extrémité de queue (3a) munie d'une partie fixe (4) noyée dans la base de connecteur (5).

5. Connecteur selon l'une quelconque des revendications 1 à 3, caractérisé en ce que l'extrémité libre du nez de contact (2) est munie d'une pièce en saillie (2b), et en ce que cette pièce en saillie (2b) et l'extrémité de queue (3a) de l'élément de support élastique (3) s'engagent toutes les deux contre des parties de la base de connecteur (5) de manière à maintenir la partie de contact de pression (6) en contact avec l'élément conducteur (7a).
